# EUROPÄISCHE PATENTANMELDUNG

(11) **EP 3 425 322 A1**
(43) Veröffentlichungstag der Anmeldung: **09.01.2019**
(21) Anmeldenummer: 18161723.4
(22) Anmeldetag: 14.03.2018
(51) Int. Cl.: F42B 15/36, F42B 30/00, F42B 15/00, F42B 15/01, H05K 3/02, H01Q 1/28

(54) **VERFAHREN ZUR HERSTELLUNG EINES FLUGKÖRPERSYSTEMBAUTEILS, FLUGKÖRPERSYSTEMBAUTEIL UND FLUGKÖRPERSYSTEMANORDNUNG**

(30) Priorität: 05.07.2017 DE 102017006362
(71) Anmelder: MBDA Deutschland GmbH, 86529 Schrobenhausen (DE)
(72) Erfinder: THIELE, Martin, 86551 Aichach (DE); HILLE, Jörg, 86565 Gachenbach (DE); LEHMANN, Stefan, 85238 Petershausen (DE)
(74) Vertreter: Isarpatent

(57) **Zusammenfassung**

Die vorliegende Erfindung betrifft ein Verfahren zur Herstellung eines Flugkörpersystembauteils, insbesondere Lenkflugkörperbauteils, mit den folgenden Verfahrensschritten: Bereitstellen eines Flugkörpersystem-Strukturbauteils mit einer vorbestimmten Oberfläche; Aufbringen einer isolierenden Zwischenschicht auf die Oberfläche; Aufbringen einer Leiterschicht auf die Zwischenschicht; und lokales Abtragen der Leiterschicht durch Laserstrahlbearbeitung. Die vorliegende Erfindung betrifft ferner derartiges ein Flugkörpersystembauteil, insbesondere Lenkflugkörperbauteil, sowie eine Flugkörpersystemanordnung mit derartigen Flugkörpersystembauteilen.

## Beschreibung

### TECHNISCHES GEBIET

Die vorliegende Erfindung betrifft ein Verfahren zur Herstellung eines Flugkörpersystembauteils, insbesondere Lenkflugkörperbauteils, ein Flugkörpersystembauteil, insbesondere Lenkflugkörperbauteil, sowie eine Flugkörpersystemanordnung.

### HINTERGRUND

Bei Flugkörpersysteme werden Leitungsführungen bisweilen mit diskreten Kabelführungen inklusive Montage der Kabelstecker sowie teilweise durch sogenannte Flex- oder Starr-Flex- Platinen vorgesehen.

### ZUSAMMENFASSUNG DER ERFINDUNG

Vor diesem Hintergrund liegt der vorliegenden Erfindung die Aufgabe zugrunde, eine verbesserte Leitungsführung bei Flugkörpersystemen bereitzustellen.

Erfindungsgemäß wird diese Aufgabe durch ein Verfahren zur Herstellung eines Flugkörpersystembauteils mit den Merkmalen des Patentanspruchs 1 und/oder ein Flugkörpersystembauteil mit den Merkmalen des Patentanspruchs 7 und/oder, eine Flugkörpersystemanordnung mit den Merkmalen des Patentanspruchs 10 gelöst.

Demgemäß ist vorgesehen:
- Ein Verfahren zur Herstellung eines Flugkörpersystembauteils, insbesondere Lenkflugkörperbauteils, mit den folgenden Verfahrensschritten: Bereitstellen eines Flugkörpersystem-Strukturbauteils mit einer vorbestimmten Oberfläche; Aufbringen einer isolierenden Zwischenschicht auf die Oberfläche; Aufbringen einer Leiterschicht auf die Zwischenschicht; und lokales Abtragen der Leiterschicht durch Laserstrahlbearbeitung.

Ein Flugkörpersystembauteil, insbesondere Lenkflugkörperbauteil, vorzugsweise hergestellt mit einem erfindungsgemäßen Verfahren, mit: einem Flugkörpersystem-Strukturbauteil; einer auf einer vorbestimmten Oberfläche des Flugkörpersystem-Strukturbauteils aufgebrachten isolierenden Zwischenschicht; und einer Leiterstruktur, welche mit einer auf die Zwischenschicht aufgebrachten Leiterschicht gebildet ist, wobei die Leiterschicht durch lokales Abtragen der Leiterschicht mittels Laserstrahlbearbeitung in Leitungen und/oder Segmente aufgetrennt ausgebildet ist.
- Eine Flugkörpersystemanordnung, mit einem ersten erfindungsgemäßen Flugkörpersystembauteil, dessen Flugkörpersystem-Strukturbauteil rohrförmig ausgebildet ist, wobei die vorbestimmte Oberfläche eine Innenfläche des rohrförmigen Flugkörpersystem-Strukturbauteils bildet; und einem zweiten erfindungsgemäßen Flugkörpersystembauteil, dessen Flugkörpersystem-Strukturbauteil zylindrisch oder rohrförmig ausgebildet ist, wobei die vorbestimmte Oberfläche eine Außenfläche des Flugkörpersystem-Strukturbauteils bildet; wobei das zweite Flugkörpersystembauteil in dem ersten Flugkörpersystembauteil, insbesondere formschlüssig, derart aufgenommen ist, dass die Innenfläche des ersten Flugkörpersystembauteils und die Außenfläche des zweiten Flugkörpersystembauteil zumindest abschnittsweise aneinander anliegen, wobei das erste und das zweite Flugkörpersystembauteil jeweils eine vorbestimmte Kontaktfläche ihrer jeweiligen Leiterstruktur aufweisen und die Kontaktflächen des ersten Flugkörpersystembauteils und des zweiten Flugkörpersystembauteils, insbesondere mittels Kraftschluss, leitend kontaktiert sind.

Die der vorliegenden Erfindung zugrunde liegende Idee besteht darin, bei einem Flugkörpersystem Leitungsführungen durch mittels Laserstrahlbearbeitung hergestellte strukturintegrierte Leiterstrukturen zu ersetzen.

Auf diese Weise wird ansonsten für die Führung von Leitungen und/oder Antennen, beispielsweise in Form von Kabeln samt Stecken, Starr-Flex- oder Flexplatinen, benötigter Bauraum frei, sodass Bauraumoptimierungen ermöglicht sind. Ferner wird Fertigungs- und Montageaufwand, insbesondere von Steckern und/oder FlexPlatinen, vermieden. Zum anderen wird auch deren Gewicht zu einem großen Anteil eingespart, was vorteilhaft die Nutzlast eines Flugkörpers erhöht und/oder hinsichtlich der Auslegung Optimierungspotenzial eröffnet.

Zur Herstellung der Leiterstruktur werden eine isolierende Zwischenschicht und eine Leiterschicht jeweils flächig aufgebracht. Beispielsweise kann die Leiterschicht dazu galvanisch hergestellt werden. Als Materialen für die Leiterschicht kommen insbesondere gut leitende Metalle, wie beispielsweise Kupfer, Nickel, Gold oder dergleichen oder derartige Metalle enthaltende Legierungen infrage.

Durch anschließendes lokales Laserstrahltrennen der Leiterschicht, beispielsweise durch Laserstrahlsublimierschneiden, wird dann die gewünschte Leiterstruktur hergestellt. Die Parameter des Laserstrahlprozesses werden dabei vorzugsweise derart gewählt, dass die Leiterschicht lokal vollständig durchtrennt wird, die Zwischenschicht aber zumindest in einem Teil ihrer Dicke in Takt bleibt bzw. in Ihrer Dicke zumindest nicht vollständig durchtrennt wird.

In Lenkflugkörpern können extreme mechanische und thermische Belastungen auftreten. Erfindungsgemäß werden nun vorteilhaft, insbesondere bei komplexer Leitungsführung, beispielsweise in engen, kleinen und/oder geometrischen ungünstigen Strukturen, derartige Belastungen der Leitungsführung dadurch besser aufgenommen, dass die Leitungsführung strukturintegriert ist. Somit wird trotz der Belastungen eine maximale Zuverlässigkeit erreicht.

Ferner ist eine derartige Leitungsführung in der erfindungsgemäßen Weise auch sehr viel einfacher, insbesondere auch in automatisierter, insbesondere CAD gestützter, Fertigung herstellbar und integrierbar. Beispielsweise können Fertigungsdaten direkt aus dem CAD abgeleitet und für die Fertigung und/oder für Vorabanalysen verwendet werden. Es ist somit eine automatisierte Prozesskette bei der Herstellung, Prüfung und/oder Integration möglich.

Insbesondere ist erfindungsgemäß auch eine sogenannte "Plug and Play" Integration der Leitungsführung möglich. Die vorliegende Erfindung ermöglicht ferner einen modularen, flexiblen Einsatz von Flugkörpersystembauteilen und/oder Subsystemen.

Ferner können dadurch, dass die Geometrie der einzelnen Leitungen mit dem Laserstrahlprozess leicht anpassbar ist, auch impedanzgesteuerte Leitungen in einfacher Weise und ohne Zusatzkosten bereitgestellt werden.

Als besonderen Vorteil erlaubt die vorliegende Erfindung die Integration von Antennenstrukturen an außenliegenden Oberflächen von Flugkörpersystembauteilen, insbesondere samt etwaiger Leitungsführung. In diesem Fall sind die mittels Laserstrahlbearbeitung hergestellten Leitungen und/oder Segmente zumindest teilweise als Antennen ausgebildet. Somit ist vorteilhaft eine Bauteilintegration geschaffen, da Leitungen/Antennen nun integral mit dem Strukturbauteil ausgebildet sind. Somit wird vorteilhaft die Bauteilanzahl für die Montage gesenkt.

Weitere Abschnitte einer Leiterstruktur sind erfindungsgemäß in vielfältiger Formherstellbar, beispielsweise als Dehnmesstreifen.

Neben der besonders vorteilhaften Ausbildung des Flugkörpersystembauteils als Lenkflugkörperbauteil kommen auch andere Bauteile eines Flugkörpersystems in Frage, beispielsweise Bauteile einer Transport- und/oder Startvorrichtung eines Flugkörpers.

Darüber hinaus sind erfindungsgemäß modulare elektrische Verbindungen erster und zweiter Flugkörpersystembauteile einfach und flexibel möglich, indem eine Kontaktierung mit einem, insbesondere bei einer formschlüssigen Verbindung der Flugkörpersystembauteile herstellbaren, Kraftschluss ermöglicht ist.

Vorteilhafte Ausgestaltungen und Weiterbildungen ergeben sich aus den weiteren Unteransprüchen sowie aus der folgenden Beschreibung.

Gemäß einer bevorzugten Ausführungsform wird die Leiterschicht durch die Laserstrahlbearbeitung zur Herstellung einer vorbestimmten Leiterstruktur in einzelne Leitungen und/oder Segmente aufgetrennt. Auf diese Weise ist eine flexible und freie Gestaltung der Leiterstruktur ohne zusätzliche Bauteile und mit geringem Aufwand möglich.

Gemäß einer vorteilhaften Weiterbildung werden durch die Laserstrahlbearbeitung zumindest teilweise mäanderförmige Leitungen hergestellt. Dadurch sind die Leitungen im Vergleich zu geraden Leitungen dehnbarer, sodass beispielsweise im Fall termischer Spannungen oder bei unterschiedlicher Wärmedehnung des Strukturteils und der Leiterschicht ein Reißen der Leitungen vermieden wird. Insgesamt wird somit die Haltbarkeit der Leitungen gewährleistet.

Gemäß einer bevorzugten Ausführungsform wird nach der Laserstrahlbearbeitung eine isolierende Schicht auf die Leiterschicht aufgetragen. Somit werden die Leitungen auf einfache Weise in einem Herstellungsschritt gemeinsam isoliert.

Ferner eröffnet die auf die Leiterschicht aufgetragene isolierende Schicht auch weitere Variationen des Aufbaus einer oder mehrerer Leiterstrukturen. Beispielsweise sind auf diese Weise sind auch mehrlagige Leiterstrukturen herstellbar, indem bei einer Ausführungsform die isolierende Schicht als weitere Zwischenschicht vorgesehen und darauf eine weitere Leiterschicht aufgebracht wird. Aus der weiteren Leiterschicht ist dann wieder durch Laserstrahlbearbeitung eine weitere Leiterstruktur herstellbar, sodass insgesamt eine mehrlagige Leiterstruktur bereitgestellt wird. Ein derartiger Schichtaufbau lässt sich bedarfsgerecht auch auf eine gewünschte Anzahl von mehr als zwei Leiter- und Zwischenschichten erweitern. Auf eine letzte Leiterschicht kann dann wieder eine (ggfs. abschließende) isolierende Schicht aufgetragen werden.

Gemäß einer vorteilhaften Ausführungsform wird eine Kontaktfläche oder ein Kontaktbereich der Leiterstruktur von der isolierenden Schicht ausgespart. Vorteilhaft ist somit auf einfache Weise eine Kontaktierung der Leiterstruktur, insbesondere ohne zusätzliche Bauteile, möglich.

Gemäß einer vorteilhaften Weiterbildung wird auf die isolierende Schicht eine Abschirmung, insbesondere in Form einer metallischen Schicht, aufgebracht. Auf diese Weise ist vorteilhaft auch eine strukturintegrierte Abschirmung bereitgestellt. Auf die Abschirmung kann selbstverständlich eine weitere nichtleitende Schicht, beispielsweise eine Lackierung oder dergleichen, aufgetragen werden. Beispielsweise kann die Abschirmung in Form einer metallischen Schicht galvanisch hergestellt werden.

Gemäß einer Ausführungsform eines Flugkörpersystembauteils ist das Flugkörpersystem.Strukturbauteil rohrförmig ausgebildet. Bei einer vorteilhaften Weiterbildung bildet die vorbestimmte Oberfläche dabei eine Innenfläche des rohrförmigen Flugkörpersystem-Strukturbauteils. Herstellbar ist diese beispielsweise mit einer in das rohrförmige Strukturbauteil einführbaren Laseroptik. Denkbar wäre alternativ oder zusätzlich zur Herstellung ein flaches Bauteil erfindungsgemäß zu bearbeiten und es anschließend zu einem Rohr zu formen, beispielsweise durch Rollen des Bauteils und Verbinden der Flanken. Somit wird die Leiterstruktur mittels Laserbearbeitung an einer inneren Umfangsfläche des rohrförmigen Strukturbauteils bereitgestellt, sodass innenliegende Module, Bauteile oder Komponenten eines Flugkörpersystems damit auf einfache Weise kontaktierbar sind. Auf diese Weise ist ein modularer, flexibler Einsatz eines Flugkörpersystembauteils ermöglicht.

Gemäß einer weiteren Ausführungsform eines Flugkörpersystembauteils ist das Strukturbauteil zylindrisch oder rohrförmig ausgebildet. Bei einer vorteilhaften Weiterbildung bildet die vorbestimmte Oberfläche dabei eine Außenfläche des Strukturbauteils.

Bei einer Ausführungsform kann ein derartiges Flugkörpersystembauteil als Au-ßenhülle oder Außenstruktur ausgebildet sein. Die Leiterstruktur kann dabei eine Antenne enthalten, die auf diese Weise vorteilhaft in das als Außenhülle oder Au-ßenstruktur ausgebildete Flugkörpersystembauteil integriert ist.

Bei einer weiteren Ausführungsform kann das Flugkörpersystembauteil auch als ein innerhalb einer Außenhülle angeordnetes Flugkörpermodul oder -element ausgebildet sein. Sofern die Außenhülle an der inneren Umfangsfläche mit Kontakten versehen ist, insbesondere als ein erstes Flugkörpersystembauteil gemäß mit rohrförmigem Strukturbauteil und innenliegender Kontaktstruktur ausgebildet ist, kann das Flugkörpersystembauteil darin dann als zweites Flugkörpersystembauteil in einer modulare Weise mit einfacher Kontaktierung über Kontaktbereiche integriert werden. Beispielsweise ist dies durch Formschluss möglich. Insbesondere ist dabei durch direkten Kraftschluss der Kontaktflächen oder gegebenenfalls über noch dazwischen angeordnete Federkontaktelemente ein einfach herzustellender definierter leitender Kontakt ermöglicht.

Die obigen Ausgestaltungen und Weiterbildungen lassen sich, sofern sinnvoll, beliebig miteinander kombinieren. Insbesondere sind sämtliche Aspekte und Merkmale eines Verfahrens zur Herstellung eines Flugkörpersystembauteils auf ein derartiges Flugkörpersystembauteil übertragbar, und umgekehrt. Selbstverständlich gilt dies auch für eine Flugkörpersystemanordnung mit derartigen Flugkörpersystembauteilen.

Mit den erfindungsgemäßen Maßnahmen können somit insgesamt Fertigungs- und Montagekosten gespart und Qualitätsstandards erhöht werden.

Erreicht wird dies unter anderem durch:
- Ergänzung der Funktionen von Strukturbauteilen um die Funktion der Strom- und Signalführung;
- auf einer vorgegebenen mechanischen Struktur wird eine isolierende Zwischenschicht aufgebracht. Auf dieser Schicht wird eine leitende Nickel, Kupfer und/oder Goldschicht aufgebracht;
- Diese leitende Schicht wird nach technischen Vorgaben mittels Laser in einzelne Leitungen/Segmente aufgetrennt;
- Diese Segmente stellen die künftigen Leitungsführungen dar. Anschließend kann nach Notwendigkeit eine weitere isolierende Schicht und/oder eine Schicht zur Abschirmung und/oder eine nicht leitende Farbschicht aufgebracht werden;
- Zwei Strukturbauteile können über ihren Formschluss gleichzeitig eine elektrische Verbindung/Kontaktierung eingehen; und/oder
- Ein definierter Kraftschluss an den Kontaktflächen ist möglich.

Darüber hinaus liegen technische Vorteile der vorliegenden Erfindung unter anderem in:
- Plug-and-Play Integration der Leitungsführung;
- Einsparung von Bauraum;
- höhere mechanische und thermische Stabilität;
- impedanzgesteuerte Leitungen ohne Zusatzkosten möglich;
- automatisierte Prozesskette bei der Herstelung/Prüfung und Integration möglich;
- Fertigungsdaten direkt aus dem CAD ableitbar für Fertigung und Voranalysen;
- modularer, flexibler Einsatz von Systemen;
- Integration von Antennenstrukturen in Strukturbauteile inkl. Leitungsführung;
- Vollständige Digitalisierung des Produktionsprozesses möglich;
- Präzisere, funktionsbezogenere Herstellung von Bauteilen und Strukturen in Flugkörpern möglich; und/oder
- exakte Reproduzierbarkeit.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen. Die vorliegende Erfindung ist auf vielfältige Art und Weise modifizierbar.

## Patentansprüche

1. Verfahren zur Herstellung eines Flugkörpersystembauteils, insbesondere Lenkflugkörperbauteils, mit den folgenden Verfahrensschritten:
Bereitstellen eines Flugkörpersystem-Strukturbauteils mit einer vorbestimmten Oberfläche;
Aufbringen einer isolierenden Zwischenschicht auf die Oberfläche;
Aufbringen einer Leiterschicht auf die Zwischenschicht; und
lokales Abtragen der Leiterschicht durch Laserstrahlbearbeitung.

2. Verfahren nach Anspruch 1, wobei die Leiterschicht durch die Laserstrahlbearbeitung zur Herstellung einer vorbestimmten Leiterstruktur in einzelne Leitungen und/oder Segmente aufgetrennt wird.

3. Verfahren nach Anspruch 2, wobei durch die Laserstrahlbearbeitung zumindest teilweise mäanderförmige Leitungen hergestellt werden.

4. Verfahren nach einem der vorangehenden Ansprüche, wobei nach der Laserstrahlbearbeitung eine isolierende Schicht auf die Leiterschicht aufgetragen wird.

5. Verfahren nach Anspruch 4, wobei eine Kontaktfläche oder ein Kontaktbereich der Leiterstruktur von der isolierenden Schicht ausgespart wird.

6. Verfahren nach Anspruch 4 oder 5, wobei auf die isolierende Schicht eine Abschirmung, insbesondere in Form einer metallischen Schicht, aufgebracht wird.

7. Flugkörpersystembauteil, insbesondere Lenkflugkörperbauteil, vorzugsweise hergestellt mit einem Verfahren nach einem der vorangehenden Ansprüche, mit:
einem Flugkörpersystem-Strukturbauteil;
einer auf einer vorbestimmten Oberfläche des Flugkörpersystem-Strukturbauteils aufgebrachten isolierenden Zwischenschicht; und
einer Leiterstruktur, welche mit einer auf die Zwischenschicht aufgebrachten Leiterschicht gebildet ist, wobei die Leiterschicht durch lokales Abtragen der Leiterschicht mittels Laserstrahlbearbeitung in Leitungen und/oder Segmente aufgetrennt ausgebildet ist.

8. Flugkörpersystembauteil nach Anspruch 7, wobei das Flugkörpersystem-Strukturbauteil rohrförmig ausgebildet ist und die vorbestimmte Oberfläche eine Innenfläche bildet.

9. Flugkörpersystembauteil nach Anspruch 7, wobei das Flugkörpersystem-Strukturbauteil zylindrisch oder rohrförmig ausgebildet ist und die vorbestimmte Oberfläche eine Außenfläche bildet.

10. Flugkörpersystemanordnung, mit
einem ersten Flugkörpersystembauteil nach Anspruch 8; und
einem zweiten Flugkörpersystembauteil nach Anspruch 9;
wobei das zweite Flugkörpersystembauteil in dem ersten Flugkörpersystembauteil, insbesondere formschlüssig, derart aufgenommen ist, dass die Innenfläche des ersten Flugkörpersystembauteils und die Außenfläche des zweiten Flugkörpersystembauteils zumindest abschnittsweise aneinander anliegen, wobei das erste und das zweite Flugkörpersystembauteil jeweils eine vorbestimmte Kontaktfläche ihrer jeweiligen Leiterstruktur aufweisen und die Kontaktflächen des ersten Flugkörpersystembauteils und des zweiten Flugkörpersystembauteils, insbesondere mittels Kraftschluss, leitend kontaktiert sind.
